Europäisches Patentamt

European Patent Office

Office européen des brevets

(11) Numéro de publication: **0 103 505**
A1

(12) # DEMANDE DE BREVET EUROPEEN

(21) Numéro de dépôt: **83401665.1**

(22) Date de dépôt: **16.08.83**

(51) Int. Cl.³: **C 03 C 17/245**, C 03 C 3/04

(30) Priorité: **18.08.82 FR 8214281**

(43) Date de publication de la demande: **21.03.84** **Bulletin 84/12**

(84) Etats contractants désignés: **DE GB IT NL**

(71) Demandeur: **COMMISSARIAT A L'ENERGIE ATOMIQUE Etablissement de Caractère Scientifique Technique et Industriel, 31/33, rue de la Fédération, F-75015 Paris (FR)**

(72) Inventeur: **Blandenet, Gérard, 28, rue Champ Rochas, F-38240 Meylan (FR)**
Inventeur: **Court, Michel, 4, Allée J. Du Bellay, F-38130 Echirolles (FR)**
Inventeur: **Lagarde Yves, 51 D, rue des Aiguynards-Meylan, F-38240 Meylan (FR)**

(74) Mandataire: **Mongrédien, André et al, c/o BREVATOME 25, rue de Ponthieu, F-75008 Paris (FR)**

(54) **Procédé de fabrication de couches minces.**

(57) Procédé de dépôt de couches minces sur un substrat (3).

Il comporte les étapes connues de création sous l'effet d'une source à ultrasons (5), d'un brouillard de fines gouttelettes à partir d'une solution de la substance à déposer et de transport de ce brouillard sur le substrat éventuellement chauffé. Il se caractérise en ce que l'on polarise électriquement la face active du substrat isolant ou isolé (3) et les gouttelettes du brouillard selon des polarités de sens opposés, à l'aide d'un champ électrostatique continu appliqué entre le brouillard et le substrat.

EP 0 103 505 A1

1

La présente invention se rapporte aux techniques de dépôt de couches minces sur un substrat ; elle s'applique de préférence mais de façon non exclusive au procédé connu sous le nom de "Pyrosol" dans lequel on commence par former à partir d'une solution du corps à déposer un brouillard de fines gouttelettes sous l'effet d'une source ultra-sonore ; dans ce procédé on règle la quantité de solution ainsi transformée en aérosol en agissant sur la puissance de la source ultra-sonore et la taille des gouttelettes constituant l'aérosol en choisissant convenablement la fréquence du générateur d'ultra-sons. On transporte ensuite, à l'aide d'un gaz vecteur, les gouttelettes d'aérosol dans une buse qui les dirige et les projette sur la face active du substrat que l'on veut recouvrir, lequel peut, dans certains cas, avoir été préalablement chauffé. Un tel procédé connu fait l'objet notamment du BF 2 110 622 déposé le 23 octobre 1970 par la demanderesse.

Le domaine d'application de la technique connue précédemment rappelée, se limite en principe au dépôt de couches minces par réaction en phase gazeuse de divers matériaux métalliques soit sous la forme métal, soit sous la forme oxyde ; de plus, malgré les qualités du procédé en question, certaines difficultés apparaissent parfois dans sa mise en oeuvre pratique, notamment en ce qui concerne la bonne homogénéisation de la répartition des gouttelettes de l'aérosol dans la phase gazeuse et ceci peut parfois conduire à des films déposés qui possèdent des épaisseurs non rigoureusement uniformes.

La présente invention a pour objet un procédé de dépôt de couches minces sur un substrat qui permet, à l'aide de moyens particulièrement simples, de favoriser la répartition de la solution sous forme de très fines gouttelettes liquides ou sous forme évaporée à la surface du substrat en évitant par conséquent l'inconvénient de l'art antérieur évoqué précédemment.

Ce procédé de dépôt de couches minces sur un substrat, qui comporte de façon connue les étapes de création, sous l'effet d'une source à ultrasons, d'un brouillard de fines gouttelettes à partir d'une solution de la substance à déposer et de transport de ce brouillard sur le substrat éventuellement chauffé, se caractérise en ce que l'on polarise électriquement la face active du substrat et les gouttelettes du brouillard selon des polarités de sens opposés, à l'aide d'un champ électrique continu appliqué entre l'aérosol et le substrat.

Le substrat utilisé selon l'invention se recouvre, sous l'influence du champ électrique, de charges électriques ; il se recouvre, sur sa face active soumise au dépôt, de charges d'un signe opposé à celui des gouttelettes de l'aérosol. Il en résulte par conséquent une polarisation du substrat qui conduit à l'établissement d'une force électrique d'intensité proprotionnelle aux charges déposées sur les gouttelettes et qui crée une attraction mutuelle entre celles-ci et le substrat. Cette attraction est très favorable à l'obtention d'une couche mince de bonne qualité en permettant notamment une répartition plus uniforme de la substance à déposer à la surface du substrat et un rendement accru du processus de dépôt.

De plus, chaque gouttelette du brouillard aérosol étant de même polarité, elles tendent à se repousser, limitant ainsi le phénomène de coalescence et améliorant l'homogénéité du brouillard.

Selon un premier mode de réalisation de l'invention, le brouillard de fines gouttelettes est formé en soumettant la totalité de la solution de la substance à déposer au contact de la source à ultrasons et en transportant ce brouillard au moyen d'un gaz vecteur.

Dans ce mode de réalisation, la source à ultrasons peut être ou non immergée dans la solution de la substance à déposer.

Selon une première variante de ce premier mode de réalisation, le brouillard de fines gouttelettes est transporté par le gaz vecteur au moyen d'une buse pourvue d'une grille métallique.

Selon une deuxième variante de ce premier mode de réalisation, le brouillard de fines gouttelettes est transporté par le gaz vecteur au moyen d'une buse formée d'une fente étroite et allongée.

Selon un deuxième mode de réalisation de l'invention, le brouillard de fines gouttelettes est formé en envoyant la solution de la substance à déposer sur un corps soumis à des vibrations ultrasonores.

Dans ce mode de réalisation, le brouillard de fines gouttelettes est projeté sur le substrat après avoir traversé un moyen de polarisation.

Selon une caractéristique secondaire de l'invention, le substrat est constitué par un matériau isolant ou isolé.

Selon une variante de cette caractéristique secondaire de l'invention, le champ électrique continu appliqué au substrat résulte d'une différence de potentiel appliquée entre la buse ou le moyen de polarisation et une électrode métallique plane située derrière le substrat isolant ou isolé, par rapport à la face active de celui-ci.

Selon un mode préféré de cette variante, l'électrode métallique plane est munie d'une pluralité de pointes dirigées vers le substrat.

Selon une autre caractéristique secondaire de l'invention, le substrat est constitué par un matériau conducteur.

De toute façon l'invention sera mieux comprise en se référant à la description d'un exemple de mise en oeuvre, donné à titre illustratif et non limitatif en se référant aux figures 1 à 5 ci-jointes sur lesquelles :

- la figure 1 montre un ensemble d'un dispositif permettant la mise en oeuvre du procédé objet de l'invention ;

- la figure 2 représente, vue en plan, la grille d'extrémité de la buse cylindrique de transport de l'aérosol ;

- la figure 3 montre un autre ensemble d'un dispositif permettant la mise en oeuvre de l'invention (substrat conducteur) ;

- la figure 4 montre l'extrémité d'une buse allongée et étroite applicable pour la mise en oeuvre de l'invention ;

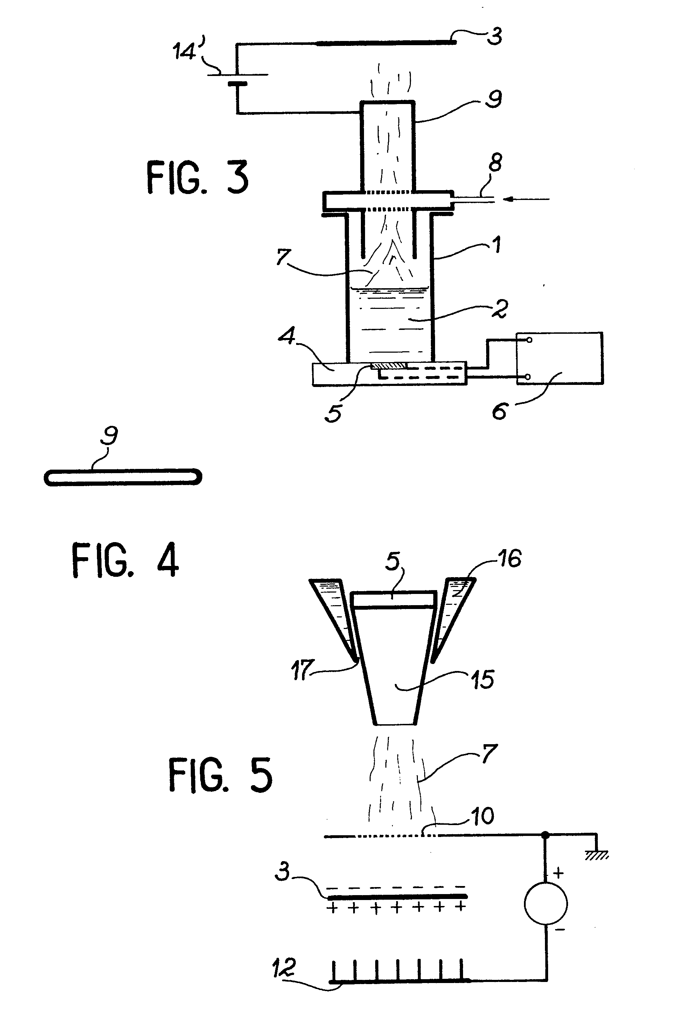

- enfin, la figure 5 représente un autre dispositif autorisant la mise en oeuvre du procédé.

Seuls ont été représentés sur ces figures les éléments nécessaires à la compréhension de l'invention, les éléments correspondants de ces différentes figures portent des nombres de référence identiques.

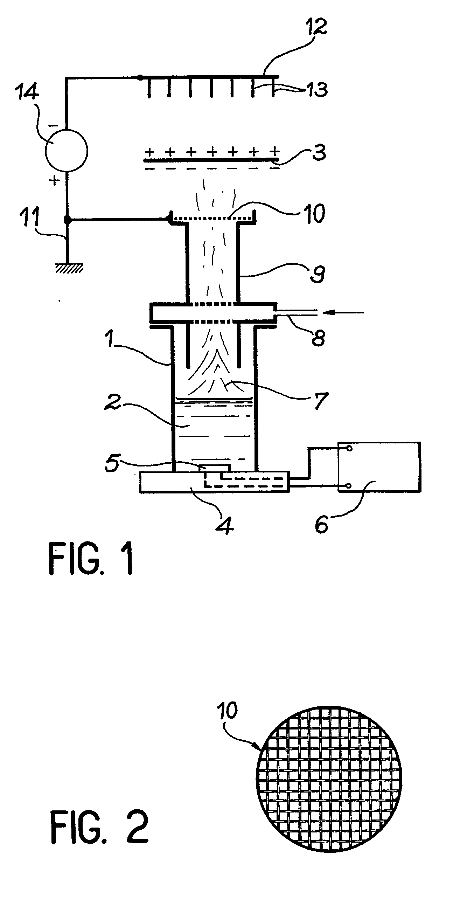

Sur la figure 1 on a représenté dans un récipient 1 la solution 2 contenant le produit à déposer en couches minces sur le substrat isolant 3. Le récipient 1 repose sur un socle 4 dans lequel se trouve un émetteur ultra-sonore 5 alimenté par un générateur de haute fréquence 6. Comme dans l'art antérieur, et de façon connue, on détermine la quantité de la solution 2 transformée en aérosol ainsi que la taille des goutellettes fines constituant cet aérosol en agissant d'une part sur la puissance du générateur de haute fréquence 6 et d'autre part en choisissant convenablement la fréquence d'oscillation de ce générateur. L'aérosol 7 ainsi constitué dans la partie supérieure du récipient 1 est soumis à l'entraînement d'un gaz vecteur introduit en 8 dans une buse cylindrique 9. Cette buse cylindrique 9 est fermée par une grille 10 dont on verra le détail de réalisation sur la figure 2. Cette grille 10 est portée au potentiel du sol par un conducteur électrique 11 et constitue l'anode d'un système à deux électrodes dont la cathode est représentée en 12 sous la forme d'une plaque métallique plane munie d'un grand nombre de pointes telles que 13 dirigées vers la surface inactive du substrat 3. Cette électrode 12 est reliée au pôle négatif d'un générateur de tension continue 14.

On voit qu'ainsi le substrat 3 est situé dans un champ électrique s'étendant entre la grille 10 et la cathode 12, ce qui conduit au développement de charges électriques négatives sur sa face active tournée vers la grille 10 et de charges électriques positives sur sa face inactive tournée vers l'électrode 12.

Le fonctionnement du dispositif décrit est alors facile à comprendre : les gouttelettes d'aérosol 7 entraînées par le gaz vecteur dans la buse cylindrique 9 acquièrent, à la sortie de celle-ci, en traversant les mailles de la grille 10 constituant l'anode du système, des charges positives ; elles sont donc de ce fait attirées avec une force électrique importante vers la surface active du substrat 3 recouverte de charges négatives. Il en résulte ainsi, comme déjà expliqué précédemment, un accroissement considérable du rendement du procédé de dépôt ainsi qu'une répartition

0103505

6

beaucoup plus homogène des gouttelettes de l'aérosol, ce qui conduit à une épaisseur beaucoup plus contrôlée de la couche mince déposée sur la face active du substrat 3.

Comme on le voit sur la figure 2, la grille 10 par exemple de forme circulaire, est constituée d'un fin grillage métallique conducteur qui ferme l'extrémité de sortie de la buse cylindrique 9 au sens électrique du terme, mais laisse un passage suffisant aux gouttelettes de l'aérosol pour quitter la buse 9.

On reconnaît sur la figure 3 le récipient 1 contenant la solution de substance à déposer 2. Le récipient 1 repose sur un socle 4 dans lequel se trouve un émetteur ultrasonore 5 alimenté par le générateur 6. On remarquera que dans cette variante, le générateur ultrasonore 5 n'est pas immergé dans la solution 2. Le brouillard de fines gouttelettes ou aérosol 7 est entraîné dans la buse métallique 9 au moyen d'un gaz vecteur entrant par 8. Cette buse 9, dans cet exemple, possède une partie supérieure de forme allongée et étroite, comme représenté sur la figure 4. Cette buse 9 est portée, par le générateur 14', à un potentiel négatif tandis que le substrat 3 est lui porté à un potentiel positif. Les gouttelettes du brouillard sortant de la buse 9 sont donc polarisées et attirées par le substrat 3 de polarité opposée.

Le fonctionnement du dispositif décrit sur cette figure 3 est analogue à celui décrit pour la figure 1. Les gouttelettes du brouillard 7 acquièrent une polarité négative en passant dans la buse 9 et sont entraînées par le gaz vecteur vers le substrat 3 de polarité opposée, la seule différence résidant dans le choix du générateur. Dans la figure 3 le substrat 3 qui est conducteur, n'est pas soumis à un champ électrique provoqué par le générateur 14', mais à une différence de potentiel avec la buse 9 au moyen du générateur de tension continu 14'.

B 7439-3 AM

Sur la figure 5, on a représenté en 3 le substrat placé de manière identique à la figure 1, dans un champ électrique créé par les électrodes 10 et 12. Sur le substrat 3 est projeté un brouillard de fines gouttelettes de la solution à déposer ; le brouillard est créé par le corps 15 solidaire d'un générateur ultrasonore 5. La solution 2 contenant la substance à déposer est, ici, contenue dans un réservoir 16, de forme cylindrotronconique par exemple, muni d'ouvertures 17 permettant l'écoulement de la solution 2 sur le corps 15. Le brouillard 7 est dirigé, suivant le procédé de l'invention, vers le substrat 3.

On doit noter d'ailleurs que le sens de ce champ peut être quelconque et que peu importe les signes de polarisation respectifs des goutellettes et de la face active du substrat, l'essentiel étant que, par influence, ces deux signes soient opposés, ce qui est la condition suffisante pour créer la force attractive.

Le procédé objet de l'invention trouve à s'appliquer dans de nombreux domaines parmi lesquels on peut citer par exemple :

- le perfectionnement du procédé antérieur décrit au début du présent texte et dans lequel le dépôt de la couche mince est obtenu par réaction en phase gazeuse au contact du substrat chauffé (BF 2 110 622).

- la répartition uniforme de composés éventuellement en solution, généralement organo-métalliques, dont la décomposition thermique ultérieure conduit à la formation d'un film mince et adhérent au substrat. C'est le cas par exemple de certains revêtements de silice $SiO_2$ sur du verre, obtenu par le procédé dit au "trempé".

- l'étalement de substances qui peuvent être déposées à température voisine de la température ambiante sans réaction chimique au contact du substrat. Dans ce cas, une légère élévation de température peut toutefois s'avérer nécessaire pour favoriser l'évaporation du solvant et simultanément, améliorer l'adhérence. C'est notamment le cas du dépôt de certaines résines photosensibles en couches minces.

EXEMPLE 1 :

Une solution de tétrabutyl orthotitanate dans l'acétate d'éthyle (concentration = 0,01 mole/litre) est pulvérisée à l'aide d'un générateur à ultrasons (800 kHz). L'aérosol formé est amené au niveau d'une grille métallique située au sommet d'un collecteur de diamètre 20 mm par un léger courant d'air (1 l/mn). La tension entre la grille métallique (mise à la terre) et l'autre électrode (dimensions 5cmx5cm) est de 90000 volts. La distance entre les deux électrodes est de 12 cm. Un substrat de verre est introduit dans le champ électrostatique à la vitesse de 1 cm/s et défile devant la buse à une distance de 8 cm. Après 4 passages, le substrat de verre est porté dans une étuve à 90°C pendant 1/2 heure pour éliminer les traces de solvant (acétate d'éthyle), puis subit un traitement thermique de 1 heure à 500°C pour transformer le film déposé en un film d'oxyde de titane ($TiO_2$).

EXEMPLE 2 :

Identique à l'exemple 1, mais l'ensemble collecteur + grille métallique est remplacé par une buse à lèvres métalliques (distance entre les lèvres 3 mm, longueur de la fente 5 cm).

EXEMPLE 3 :

Identique à l'exemple 1, le tétrabutyl orthosilicate étant utilisé à la place du tétrabutyl orthotitanate, le revêtement obtenu après traitement thermique étant alors de la silice ($SiO_2$).

B 7439-3 AM

EXEMPLE 4 :

Identique à l'exemple 1, mais le substrat est métallique ou conducteur et joue lui-même le rôle d'électrode.

10

REVENDICATIONS

1. Procédé de dépôt de couches minces sur un substrat qui comporte, de façon connue, les étapes de création sous l'effet d'une source à ultrasons (5), d'un brouillard de fines gouttelettes à partir d'une solution de la substance à déposer et de transport de ce brouillard sur un substrat (3) éventuellement chauffé, caractérisé en ce que l'on polarise électriquement la face active du substrat (3) et les gouttelettes du brouillard selon des polarités de sens opposé, à l'aide d'un champ électrique continu appliqué entre le brouillard et le substrat.

2. Procédé selon la revendication 1, caractérisé en ce que la totalité de la solution (2) est mise en contact avec la source à ultrasons (5) et en ce que le brouillard de fines gouttelettes (7) est transporté au moyen d'un gaz vecteur.

3. Procédé selon l'une quelconque des revendications 1 et 2, caractérisé en ce que la source à ultrasons (5) est immergée dans la solution (2).

4. Procédé selon l'une quelconque des revendications 1 et 2, caractérisé en ce que la source à ultrasons (5) est extérieure à la solution (2).

5. Procédé selon l'une quelconque des revendications 2 à 4, caractérisé en ce que le brouillard de fines gouttelettes est transporté par le gaz vecteur au moyen d'une buse métallique (9) pourvue d'une grille métallique (10).

6. Procédé selon l'une quelconque des revendications 2 à 4, caractérisé en ce que le brouillard de fines gouttelettes est transporté par le gaz vecteur au moyen d'une buse pourvue d'une fente étroite et allongée.

7. Procédé selon la revendication 1, caractérisé en ce que le brouillard de fines gouttelettes est formé en envoyant la solution de la substance à déposer (2) sur un corps (15) soumis à des vibrations ultrasonores.

B 7439-3 AM

8. Procédé selon l'une quelconque des revendications 1 à 7, caractérisé en ce que le substrat (3) est un matériau isolant ou isolé.

9. Procédé selon l'une quelconque des revendications 1 à 7, caractérisé en ce que le substrat (3) est un matériau conducteur.

10. Procédé selon l'une quelconque des revendications 1 à 9, caractérisé en ce que le champ électrique appliqué au substrat (3) résulte d'une différence de potentiel entre la buse (4) ou le moyen de polarisation (10) et une électrode métallique plane (12) située derrière le substrat (3).

11. Procédé selon la revendication 10, caractérisé en ce que l'électrode métallique (12) est munie d'une pluralité de pointes (13).

FIG. 1

FIG. 2

FIG. 3

FIG. 4

FIG. 5

0103505

Office européen
des brevets

**RAPPORT DE RECHERCHE EUROPEENNE**

Numéro de la demande

EP  83 40 1665

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. 3) |
|---|---|---|---|
| A | CHEMICAL ABSTRACTS, vol. 95, 1981, page 240, résumé no. 101722d, COLUMBUS, Ohio (US) G. BLANDENET et al.: "Completion of a prototype installation for in-line coating by the Pyrosol process for the realization of selective glazings" & Energy Res. Abstr. 1981, 6(1), Abstr. No. 553 | | C 03 C 17/245 C 03 C 3/04 |
| | --- | | |
| A | CHEMICAL ABSTRACTS, vol. 94, 1981, page 280, résumé no. 161235m, COLUMBUS, Ohio (US) G. BLANDENET et al.: "Development of a prototype coatings installation by the Pyrosol process for the making of selective glasses" & Comm. Eur. Communities, (Rep) EUR 1980, EUR 6806, 43 pp. | | DOMAINES TECHNIQUES RECHERCHES (Int. Cl. 3) |
| | --- | | |
| A,D | FR-A-2 110 622 (C.E.A.) | | C 23 C C 03 C B 05 D |
| | --- | | |
| A | FR-A-2 031 117 (RANSBURG ELECTROCOATING CORP.) | | |
| | --- | | |
| A | US-A-3 645 778 (NESTERUK) | | |
| | --- | | |
| A | GB-A-1 307 361 (PILKINGTON) | | |
| | --- -/- | | |

Le présent rapport de recherche a été établi pour toutes les revendications

| Lieu de la recherche LA HAYE | Date d'achèvement de la recherche 28-11-1983 | Examinateur NGUYEN THE NGHIEP |
|---|---|---|

Office européen
des brevets

**RAPPORT DE RECHERCHE EUROPEENNE**

| | **DOCUMENTS CONSIDERES COMME PERTINENTS** | | Page  2 |
|---|---|---|---|

| Catégorie | Citation du document avec indication, en cas de besoin, des parties pertinentes | Revendication concernée | CLASSEMENT DE LA DEMANDE (Int. Cl. ³) |
|---|---|---|---|
| A | FR-A-2 202 857  (ENGELHARD) | | |

-----

DOMAINES TECHNIQUES
RECHERCHES (Int. Cl. ³)

Le présent rapport de recherche a été établi pour toutes les revendications

| Lieu de la recherche LA HAYE | Date d'achèvement de la recherche 28-11-1983 | Examinateur NGUYEN THE NGHIEP |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503. 03.82